(19) Europäisches Patentamt

European Patent Office

Office européen des brevets

(11) Publication number: **0 153 020**
A2

## (12) EUROPEAN PATENT APPLICATION

(21) Application number: 85300390.3

(22) Date of filing: 21.01.85

(51) Int. Cl.⁴: **H 03 H 11/22**

(30) Priority: 16.02.84 CA 447591

(43) Date of publication of application: 28.08.85
Bulletin 85/35

(84) Designated Contracting States: **AT DE FR GB NL SE**

(71) Applicant: **NORTHERN TELECOM LIMITED,**
1600 Dorchester Boulevard West, Montreal Quebec
H3H 1R1 (CA)

(72) Inventor: **Gawargy, Mumtaz Basta, 467-A Moodie Drive,
Nepean Ontario K2H 8T7 (CA)**

(74) Representative: **Crawford, Andrew Birkby et al, A.A.
THORNTON & CO. Northumberland House 303-306 High
Holborn, London WC1V 7LE (GB)**

(54) **Symmetrical polyphase networks.**

㊻ A symmetrical polyphase network including a plurality of
cascaded network sections (1 to 7) includes (651 to 654) buff-
ers coupling two adjacent sections (6, 7), enabling a greater
number of network sections to be provided whilst still improv-
ing network performance. Capacitors (111 to 114, ... 711 to
714) of all of the network sections (1 to 7) have the same nomi-
nal capacitance to simplify manufacture.

EP 0 153 020 A2

1

## SYMMETRICAL POLYPHASE NETWORKS

This invention relates to symmetrical polyphase networks, which are also known as sequence discriminators.

It is known, for example from Mikhael U.S. Patent No. 4,123,712 issued October 31, 1978, to provide a symmetrical polyphase network which comprises a plurality of cascaded network sections each consisting of a plurality of resistors and capacitors connected alternately in series in a ring, with alternate junction points providing inputs and outputs of the network section. Each network section has for example four resistors, all having the same nominal resistance, and four capacitors, all having the same nominal capacitance, to provide a response having a notch at a frequency determined by the resistance and capacitance, the different cascaded sections providing notches at different frequencies to provide an overall desired response.

As disclosed in the above patent, symmetrical polyphase networks are of particular use in single sideband amplitude modulation arrangements. With increasingly high performance required of such arrangements, increasing demands have been placed on the performance of symmetrical polyphase networks, in particular to provide a high attenuation ($>60dB$) in the stop-band of the network. This has necessitated providing networks with greater numbers of network sections coupled together in cascade.

It has been found that, due to such things as component tolerances and interactions between the different network sections, an increase in the number of network sections of a symmetrical polyphase network beyond about six sections does not result in improvement of the response of the network. This limits the extent to which symmetrical polyphase networks can be enlarged to meet increasingly stringent demands. Furthermore, such stringent demands have required very close tolerance components to be used in the networks, increasing their costs and difficulty of manufacture.

An object of this invention, therefore, is to provide an improved symmetrical polyphase network.

0153020

2

According to this invention there is provided a symmetrical polyphase network comprising first and second symmetrical polyphase network sections and buffer means coupling said network sections together in cascade.

The provision of the buffer means, which conveniently comprises unity-gain buffer amplifiers, provides an isolation between the different network sections whereby the number of sections can be increased beyond about six, for example to seven or more. In this case the further network sections are conveniently directly coupled in cascade with the first and second network sections, preferably so that the first and second network sections are the first two or the last two of the network sections in the network.

Conveniently each network section comprises a plurality of first impedance means and a like plurality of second impedance means connected alternately in series in a ring, the first impedance means and the second impedance means having different phase angles, junction points between said impedances around said ring constituting alternately inputs and outputs of the network section. Preferably the first impedance means comprises a resistive impedance such as a resistor and the second impedance means comprises a reactive impedance such as a capacitor.

Whereas in prior symmetrical polyphase networks the resistance and capacitance values for each network section have been determined individually for the different sections, it has been found advantageous to select the capacitance values so that the capacitors of all of the network sections have the same nominal capacitance. This simplifies manufacture of the networks as only a single capacitance value is used throughout, and furthermore reduces, in comparison to the prior art, the variation in resistance values for the resistors in the different network sections, thereby further facilitating manufacture.

The invention also embraces a single sideband modulation arrangement comprising a symmetrical polyphase network as recited above, means for supplying a modulating signal to said network and deriving a symmetrical polyphase modulating signal

3

therefrom, means for producing a symmetrical polyphase carrier signal, and modulating means responsive to the symmetrical polyphase carrier signal and the symmetrical polyphase modulating signal for producing a single sideband modulated signal.

The invention will be further understood from the following description with reference to the accompanying drawings, in which:

Fig. 1 schematically illustrates by way of example a symmetrical polyphase network in accordance with the invention;

Fig. 2 is a block diagram illustrating the manner in which such networks can be used in a single sideband modulation and demodulation arrangement; and

Fig. 3 is a graph illustrating theoretical and measured responses of a network as illustrated in Fig. 1 used in an arrangement as illustrated in Fig. 2.

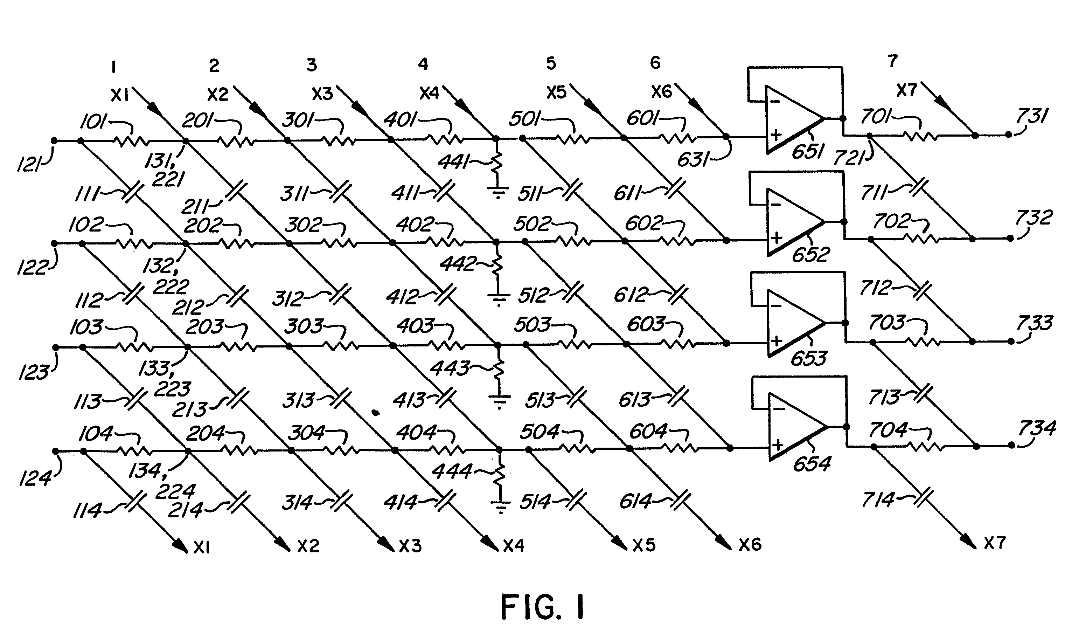

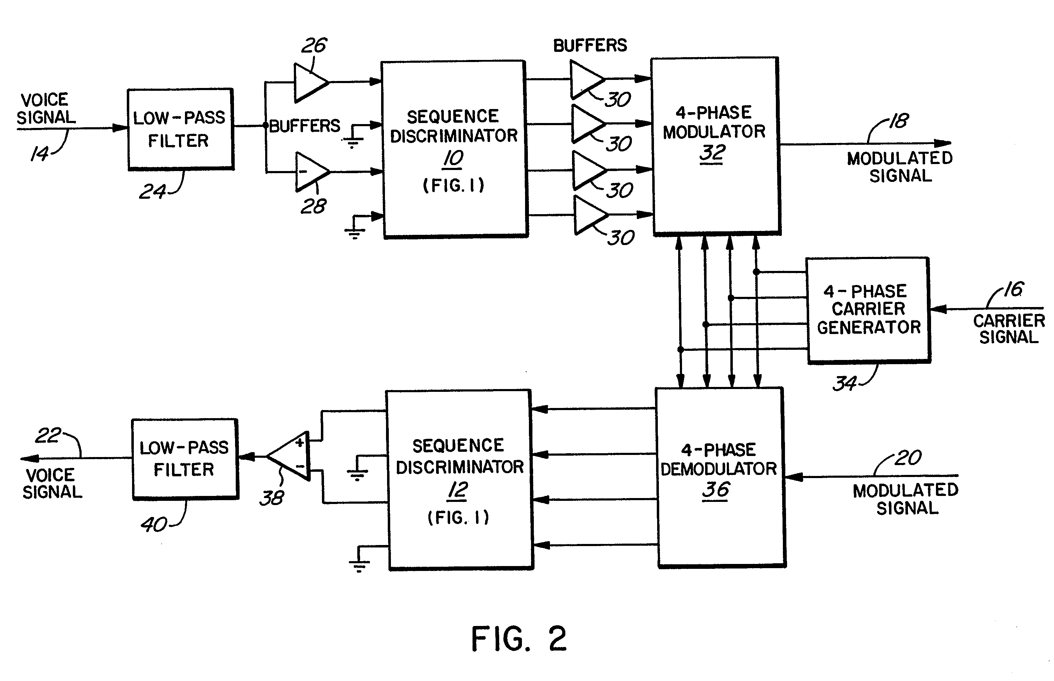

Referring to Fig. 1, there is illustrated therein a symmetrical polyphase network which comprises seven cascaded symmetrical polyphase network sections 1 to 7. Each network section comprises four resistors, e.g. 101 to 104 for the network section 1, and four capacitors, e.g. 111 to 114 for the network section 1, which are connected alternately in series in a ring. For clarity in the drawing, connections between the bottom and top of the figure for the different network sections, for example between the capacitor 114 and the resistor 101 in the network section 1, which complete the network section rings are represented only by arrows and associated references X1 to X7.

The junction points between the resistors and capacitors of each network section 1 of the cascaded network sections, which inputs are referenced 121 to 124, constitute four symmetrical polyphase inputs of the network. The four inputs of each following network section 2 to 7 are coupled as described below to the four outputs of the respective preceding network section 1 to 6. The four outputs of the final network section 7 are referenced 731 to 734 and constitute four symmetrical polyphase outputs of the network.

4

The network sections 1 to 5 are directly coupled to the respective following network sections 2 to 6 in that the four outputs of each network section are connected directly each to a respective one of the four inputs of the following network section in a symmetrical manner. Thus for example the outputs 131 to 134 of the network section 1 are constituted by the same junctions as the inputs 221 to 224 respectively of network section 2. In addition to being directly coupled in this manner, the outputs of the network section 4 are coupled to circuit ground via respective resistors 441 to 444, which serve to reduce ripple in the pass-band of the network as described in U.S. Patent No. 4,123,712.

In accordance with this invention, the outputs of the network section 6 are coupled to the respective inputs of the network section 7 via buffers 651 to 654, instead of directly. As illustrated, each buffer is constituted by a unity-gain differential amplifier whose output is connected to its inverting input and to the respective input of the following network section and whose non-inverting input is connected to the respective output of the preceding network section. Thus for example the buffer amplifier 651 has its non-inverting input connected to the output 631 of the network section 6 and its output connected to the input 721 of the network section 7.

Fig. 2 illustrates a single sideband modulation and demodulation arrangement which uses two symmetrical polyphase networks each as illustrated in Fig. 1. The two networks constitute sequence discriminators 10 and 12 respectively.

The arrangement shown in Fig. 2 serves for single sideband modulation of a baseband voice frequency signal incoming on a line 14 onto a carrier signal supplied on a line 16 to produce a modulated signal on a line 18, and to demodulate a modulated signal incoming on a line 20 to produce an outgoing demodulated voice frequency signal on a line 22. Such an arrangement may typically be used in a radio transmission system for transmitting voice frequency signals such as telephony signals in both directions of transmission

5

in a 4kHz wide band either above or below the carrier signal frequency.

To this end the voice signal on the line 14 is passed through a low-pass filter 24 to remove signal frequencies above 4kHz, and thence via a non-inverting buffer 26 and an inverting buffer 28 to oppositely-phased inputs of the sequence discriminator 10, the other two inputs of which are grounded. A resultant symmetrical 4-phase voice frequency signal is supplied from the sequence discriminator 10 via buffers 30 to a 4-phase modulator 32, which is also supplied with a 4-phase carrier produced from the carrier signal on the line 16 by a 4-phase carrier generator 34. The modulator 32 produces the modulated signal on the line 18 as a single sideband, for example the upper sideband, signal in known manner - see for example the article "Sequence Discriminators and Their Use in Frequency Division Multiplex-Communication Systems" by Wasfy B. Mikhael, IEEE Transactions on Circuits and Systems, Vol. CAS-26, No. 2, February 1979, pages 117 to 129.

Conversely, and likewise in known manner, the voice signal on the line 22 is produced from the modulated signal on the line 20 by demodulation in dependence upon the 4-phase carrier in a 4-phase demodulator 36, sequence discrimination in the network 12, production of a single phase signal by a differential amplifier 38, and low-pass filtering of this signal in a low-pass filter 40. As the form of this arrangement, apart from the sequence discriminators or symmetrical polyphase networks 10 and 12 of Fig. 1, is known, this need not be described further here.

It has been determined that in a system using arrangements such as that shown in Fig. 2, there should be at least 60dB of rejection of signals outside the desired frequency band. For this to be achieved, the sequence discriminator 10 with the modulator 32, and the sequence discriminator 12 with the demodulator 36, should each provide at least 60dB of rejection of signals in the unwanted sideband (e.g. the lower sideband where the upper upper sideband is transmitted) in a frequency range from 600Hz to 3300Hz. This is a stringent requirement which, in addition to other requirements such

6

as low ripple in the pass-band, has been very difficult or impossible to meet in practice using known sequence discriminators, due to the limited number of network sections which can be provided whilst still improving performance, and the very close tolerance components which in this case are required.

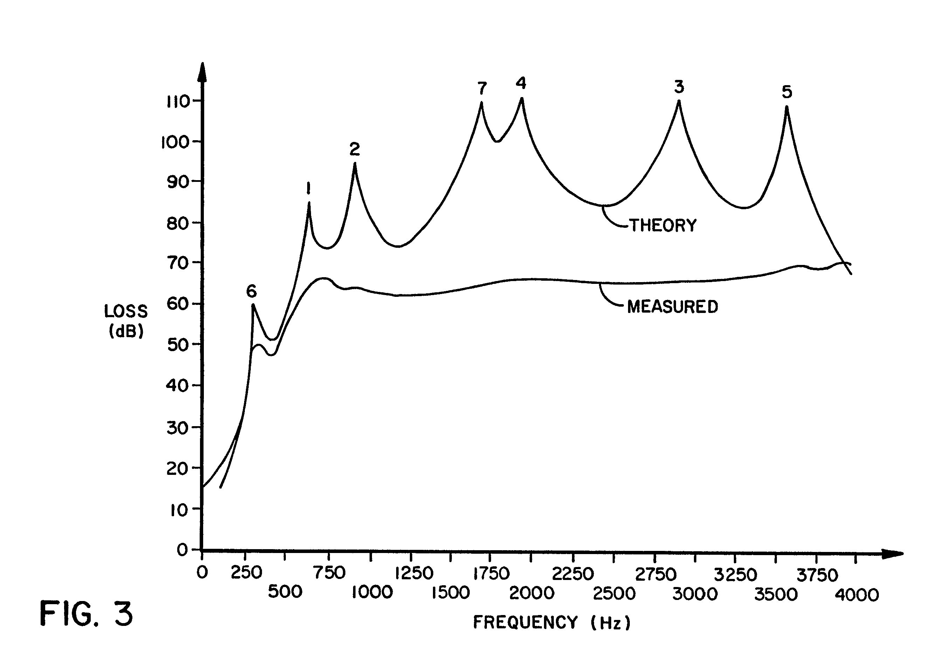

In contrast to the prior art, use of a network as shown in Fig. 1 in the arrangement of Fig. 2 enables these requirements to be met. Fig. 3 is a graph illustrating the theoretical and measured loss in the stop-band of an optimized symmetrical polyphase network as illustrated in Fig. 1 together with a 4-phase modulator as shown in Fig. 2. As the loss is also dependent on the phasing of the 4-phase carrier signals supplied by the generator 34, it is observed that the curves in Fig. 4 are also dependent upon these carrier phases having a timing (phase) error of less than 1 nanosecond.

As shown in Fig. 3, the measured performance of the sequence discriminator and modulator shows a loss of at least 62dB throughout the frequency band of interest, namely 600Hz to 3300Hz. The theoretical curve shows seven distinct peaks which correspond to the notch frequencies of the individual network sections, and which are numbered from 1 to 7 to relate them to the relevant network sections. It should be noted that the order of the peaks across the frequency spectrum does not correspond to the order of the network sections, and in particular that the network section 7 which is coupled to the remainder of the network via the buffers 651 to 654 produces a peak in the middle of the frequency spectrum. It should also be noted that in the measured curve the individual peaks are greatly smoothed out, due to interaction between the different network sections and component tolerances.

In order to determine a suitable design of network as shown in Fig. 1 for producing the measured response in Fig. 3, known filter design techniques are used to determine and optimize component values in the network, given the desired response, number of network sections, and other predetermined parameters. In order to facilitate manufacture, one of these other parameters is selected as the requirement that all of the capacitors in all of the network sections have the same capacitance. This means that in manufacture only one capacitor value need be provided, and there is no risk of mixing up capacitors of differing values in different network sections and thereby rendering the network useless.

The above design and optimizing steps are repeated as desired and the performances of the resultant networks are simulated, to determine an optimized form of the network. Such an optimized form of network for the application in Fig. 2 and the response in Fig. 3 is that illustrated in Fig. 1. In this case the same network design is intended for use for both sequence discriminators 10 and 12 in Fig. 2, but this need not be the case. In particular, it is believed advantageous to provide the buffers 651 to 654 between the two network sections which are closest to the modulator 32 or demodulator 36; i.e. between the last two network sections for the sequence discriminator 10 and between the first two network sections for the sequence discriminator 12. The use of the same network design for both sequence discriminators does not achieve this, but provides the offsetting advantage that only one network design need be provided.

For the measured response in Fig. 3, the network design in Fig. 1 had capacitors 111 to 114, 211 to 214, ...711 to 714 which all had a nominal capacitance of 2.2nF and a tolerance of ±1%, resistors 441 to 444 each trimmed to a nominal resistance of 35.50351 kilohms, and other resistors with nominal resistances given in the following table:

| Network Section | Resistors | Resistance (kilohms) | Notch Frequency (Hz) |
|---|---|---|---|
| 1 | 101 to 104 | 114.2238 | 633.34573 |
| 2 | 201 to 204 | 78.57070 | 920.73961 |
| 3 | 301 to 304 | 24.75731 | 2922.0927 |
| 4 | 401 to 404 | 36.89227 | 1960.9299 |
| 5 | 501 to 504 | 20.10945 | 3597.4707 |
| 6 | 601 to 604 | 226.3894 | 319.55187 |
| 7 | 701 to 704 | 42.40165 | 1706.1400 |

8

It should be noted that the resistances of the resistors in the network vary within a range of less than 12:1, which is a reduction from the variation of about 25:1 in the prior art (10 to 250 kilohms in the IEEE article referred to above, at page 120) and facilitates manufacture of the network.

The network is conveniently manufactured using thick film techniques with the resistors having a rough tolerance, for example ±30%, about a value from which they can be laser trimmed in known manner to their desired resistances with a tolerance of ±0.5% generally and ±0.25% for the resistors in the network section closest to the modulator or demodulator. In this respect the resistors are advantageously trimmed individually by the method described and claimed in our copending patent application entitled "Trimming Resistances in Symmetrical Polyphase Networks" filed simultaneously herewith. This method comprises trimming each resistor of each network section so that the product of its resistance and the measured capacitance of the capacitor connected to the same output of the same network section is equal to the product of the nominal resistance and nominal capacitance of the resistors and capacitors of the respective network section. Thus for example the resistor 101 would be trimmed to a resistance whose product with the measured capacitance of the capacitor 114 is equal to the product of 114.1128 kilohms and 2.2nF. It is observed, however, that trimming of the resistors in some of the network sections, particularly those furthest from the modulator or demodulator, whose accuracy least affects the overall performance of the network, may be omitted without seriously affecting the network performance.

Although a particular embodiment of the invention has been described, the invention is not limited to the particular details thereof, and numerous modifications, variations, and adaptations may be made thereto without departing from the scope of the invention, which is defined by the claims. In particular it should be noted that buffers may be provided between adjacent network sections at one or more locations other than that illustrated in Fig. 1, resistors such as the resistors 441 to 444 may be omitted or

9

provided in other network sections, different numbers and arrangements of network sections may be provided, and the buffers may if desired be arranged to provide gain or loss rather than being unity-gain buffers.

WHAT IS CLAIMED IS:

1.   A symmetrical polyphase network comprising (6) first and second (7) symmetrical polyphase network sections, characterized by buffer means (651 to 654) coupling said network sections (6, 7) together in cascade.

2.   A network as claimed in claim 1 and including one or more further symmetrical polyphase network sections (1 to 5) which are directly coupled in cascade with said first and second network sections (6, 7).

3.   A network as claimed in claim 2 wherein there is a total of at least seven network sections (1 to 7).

4.   A network as claimed in claim 3 wherein said first and second network sections (6, 7) are the first two or the last two of the network sections (1 to 7) in the network.

5.   A network as claimed in any of claims 1 to 4 wherein each network section (1 to 7) comprises a plurality of resistors (101 to 104, 201 to 204...) and a plurality of capacitors (111 to 114, 211 to 214...), all of said capacitors of all of the network sections having the same nominal capacitance.

6.   A network as claimed in any of claims 1 to 4 wherein each network section (1 to 7) comprises a plurality of first impedance means (101 to 104, 201 to 104...) and a like plurality of second impedance means (111 to 114, 211 to 214...) connected alternately in series in a ring, the first impedance means and the second impedance means having different phase angles, junction points between said impedances around said ring constituting alternately inputs (121 to 124, 221 to 224...) and outputs (131 to 124, 231 to 234...) of the network section (1, 2...).

11

7.    A network as claimed in claim 6 wherein each first impedance means comprises a resistive impedance and each second impedance means comprises a reactive impedance.

8.    A network as claimed in claim 6 wherein each first impedance means comprises a resistor and each second impedance means comprises a capacitor.

9.    A network as claimed in claim 8 wherein the capacitors in all of said network sections (1 to 7) have the same nominal capacitance.

10.    A network as claimed in any of claims 1 to 9 wherein the buffer means comprises unity-gain buffer amplifiers (651 to 654) coupled between said first and second network sections (6, 7).

11.    A single sideband modulation arrangement comprising a symmetrical polyphase network (10) as claimed in any of claims 1 to 10, means (26, 28) for supplying a modulating signal to said network and deriving a symmetrical polyphase modulating signal therefrom, means (34) for producing a symmetrical polyphase carrier signal, and modulating means (32) responsive to the symmetrical polyphase carrier signal and the symmetrical polyphase modulating signal for producing a single sideband modulated signal.

FIG. I

2/3

FIG. 2

FIG. 3

01153020